# EUROPEAN PATENT APPLICATION

(11) **EP 4 808 135 A1**
(43) Date of publication of application: **16.09.2026**
(21) Application number: 25162644.6
(22) Date of filing: 10.03.2025
(51) Int. Cl.: H04N 23/50, H04N 23/51, H04N 23/52, H04N 23/55, H04N 23/57, G02B 7/02, G03B 17/55, G03B 30/00, H05K 1/02, H05K 7/20

(54) **AUTOMOTIVE CAMERA WITH A HEAT TRANSFER ELEMENT**

(71) Applicant: Connaught Electronics Ltd., County Galway H54 Y276 (IE)
(72) Inventor: PAULRAJ, Richards, 600130 Chennai (IN); RANA, Gyana-Ranjan, 600130 Chennai (IN); SIDDHARTH, Partha, 600130 Chennai (IN)
(74) Representative: Jauregui Urbahn, Kristian

(57) **Abstract**

Automotive camera (2) comprising a housing (4a, 4b) and a circuit board (7), which is arranged within a housing interior of the housing (4a, 4b). The circuit board (7) is connected to the housing (4a, 4b) by a pin (5). The automotive camera (2) is comprising a heat transfer element (6), wherein the pin (5) passes through the heat transfer element (6) and the heat transfer element (6) is in contact with the housing (4a, 4b) via a first surface (11a) of the heat transfer element (6) and with the circuit board (7) via a second surface (11b) of the heat transfer element (6).

## Description

The present invention is directed to an automotive camera comprising a housing and a circuit board, which is connected to the housing by a pin. Furthermore, the invention is directed to a motor vehicle and a method for manufacturing an automotive camera.

Cameras, which are designed to be arranged on motor vehicles, may be denoted as automotive cameras. Automotive cameras depicting an exterior environment of the motor vehicle are used for various driver assistance functions or other functions for partially or fully automatic driving of a motor vehicle. However, automotive cameras may also be employed for the capturing an interior of the vehicle and may be arranged correspondingly. Thus, automotive cameras may be exposed to significant temperature fluctuations and/or other environmental conditions. Moreover, automotive cameras are also exposed to mechanical stress due to the vibrations while the vehicle is moving. Automotive cameras for motor vehicles should therefore be designed to operate as desired under said conditions and to achieve sufficiently good image quality. The images may then be provided to driver assistance systems or other electronic vehicle guidance systems, which may use them as an input for driver assistance or at least partly automatically guiding the vehicle.

Within the housing of the automotive camera, a housing interior is formed and the circuit board is usually arranged within the housing interior. The circuit board is connected to the housing by the pin. The pin may guide the circuit board to a mounting position during a manufacturing process and may also serve as a fixation when the mounting position is reached.

In order to achieve the good image quality the circuit board may generate heat, which needs to be dissipated for an error-free operation of the circuit board. An effective cooling of the circuit board is necessary.

It is an objective of the present invention to improve the heat dissipation of a circuit board of an automotive camera.

This objective is achieved by the respective subject matter of the independent claims. Further implementations and preferred embodiments are subject matter of the dependent claims.

The invention is based on the idea to increase the heat transfer rate of the occurring heat from a source of the occurring heat, which is located on the circuit board, to a drain, which is the housing of the automotive camera.

According to an aspect of the invention, an automotive camera is provided. The automotive camera comprises a housing and a circuit board, which is arranged within a housing interior of the housing. The circuit board is connected to the housing by a pin. Additionally the automotive camera comprises a heat transfer element, wherein the pin passes through the heat transfer element and the heat transfer element is in contact, in particular in direct contact, with the housing via a first surface of the heat transfer element and with the circuit board via a second surface of the heat transfer element.

In particular, a mounting position of the circuit board with the housing may for example be aligned with the pin. In some embodiments, the circuit board is connected to the housing by the pin and one or more additional pins. Other than via the pin and, if applicable, the one or more additional pins, the circuit board may especially not be in direct physical connection with the housing.

The pin may for example be part of the housing and shaped as a protruding part of the housing. Alternatively, the housing may comprise a blind hole or a through hole. The pin may be an individual part, which is connected to the blind hole or the though hole of the housing or another portion of the housing via a clamping process, a gluing process, a bonding process or as a rivet. The pin may also be screwed to the housing or the pin itself may be designed as a screw.

The pin may be connected to the circuit board, such that the pin is inserted through a hole of the circuit board. The hole of the circuit board may be shaped as a round hole, an elongated hole or a slot. The hole may also be open to the edge of the circuit board. Alternatively, the pin may touch the circuit board on a surface of the circuit board or be inserted into a blind hole of the circuit board. The pin may also be soldered or glued to the circuit board. The pin may also be a part of the circuit board and shaped as a protruding part of the circuit board.

The circuit board may, in some embodiments, be connected to the housing by at least one additional pin. The at least one additional pin may be designed, so that the circuit board is mounted to a defined mounting position. The at least one additional pin may be connected to the circuit board according to the description above for the pin. The pin and the at least one additional pin may be connected to the circuit board in a same way or in different ways. The at least one additional pin may be connected to the housing according to the description above. The pin and the at least one additional pin may be connected to the housing in a same way or in different ways.

The circuit board may for example comprise a printed circuit board and may have the form of a laminated sandwich structure of at least one conductive and at least one insulating layer. Each of the at least one conductive layer may be designed with a pattern of traces, planes and other features, which may be similar to wires on a flat surface. The traces, planes and other features may for example be etched from the at least one conductive layer from a conductive material, such as copper, laminated onto or between the at least one insulating layer of a non-conductive substrate. The circuit board may comprise at least one electrical component, which may be assembled to at least one conductive pad on an outer layer of the circuit board, especially by means of soldering, which electrically connects the at least one electrical component to the outer layer.

The circuit board may for example comprise an imager chip, which may be designed to generate an image of part of a surrounding scenery of the automotive camera. The imager chip may for example form a flat structure and may be fixed to the circuit board, especially soldered to the circuit board, such that a light sensitive area of the imager chip is uncovered, meaning that no other part of the circuit board is blocking a line of sight of the light sensitive area of the imager chip.

The automotive camera may for example comprise a lens unit. The housing may comprise a lens opening and the lens unit may be connected to the lens opening or to the housing at the lens opening. The lens opening may be designed such that incident light can penetrate the lens unit and the lens opening and hit the imager chip. The light sensitive area of the imager chip may be perpendicular to an optical axis of the lens unit.

The housing may comprise at least one piece and leave the housing interior as an open space, where for example the circuit board may be arranged. The housing may comprise a thermally conductive material.

The heat transfer element may for example comprise a through hole, which may be designed to fit the pin. The heat transfer element may fill or bridge a gap between circuit board and the housing. The heat transfer element may for example be shaped as a hollow cylinder, as a rectangular block or as a spring. Especially the heat transfer element may comprise or consist of a thermally conductive material.

The first surface of the heat transfer element may be a plane surface and be in direct contact with the housing across an entire area of the first surface. In particular, the first surface may lie flat on the housing. The second surface of the heat transfer element may be a plane surface and be in direct contact with the circuit board across an entire area of the second surface. In particular, the second surface may lie flat on the circuit board.

An advantage of the implementations described above is an increased heat dissipation of occurring heat within the automotive camera by providing an additional channel for heat transfer from the circuit board to the housing via the heat transfer element. Especially if the housing interior is sealed from the environment outside the automotive camera, occurring heat may be captured within the housing interior. Especially the circuit board, in particular the imager chip of the circuit board, may generate heat during operation. A constant operation over a certain period of time may lead to overheat of the imager chip and may limit a performance, lead to a functional failure or even a destruction of the imager chip or other components of the automotive camera or the circuit board. The heat transfer element may establish a heat dissipation from a heat source, which may be the imager chip, via the heat transfer element to the heat drain, which may be the housing and thus to the environment of the automotive camera.

According to at least one embodiment, a surface of the circuit board is parallel or approximately parallel to a surface of the housing.

According to at least one embodiment a gap between a surface of the circuit board and a surface of the housing is formed, wherein the gap is at least partially filled or is bridged by the heat transfer element.

In other words, the circuit board may not be in direct contact with the housing except via the pin and, if applicable, the one or more additional pins. The gap may be at least partially filled by the heat transfer element or in particular partially filled by the heat transfer element. In the case, the gap is partially filled by the heat transfer element, the heat transfer element may only fill the gap in a vicinity of the pin, meaning for example within a radius of 1 mm to 10 mm around the pin. The circuit board may comprise other regions, where the gap is not filled, but left for example empty.

The gap may extend over a distance of 0.1 mm to 10 mm with a typical value of 2-3 mm. The heat transfer element may partially fill the gap, meaning, that the circuit board may rest on the heat transfer element in a gapless fashion and the heat element may rest on the housing in a gapless fashion.

An advantage of the implementations described above is the flexible arrangement of the circuit board within the housing interior. The circuit board may have a degree of freedom during the assembly process in the housing interior, which might be necessary for alignment e.g. with the optical axis of the lens unit. Filling the gap may increase the heat transfer rate from the circuit board to the housing.

According to at least one further embodiment, the heat transfer element and/or the housing comprises a thermally conductive material.

A thermal conductivity of a material is a measure of its ability to conduct heat and may be measured in W/(m*K). Heat transfer may occur at a lower rate in materials of low thermal conductivity compared to materials of high thermal conductivity. For instance, metals may typically have a high thermal conductivity and thus may be efficient at conducting heat, while thermally insulating materials may have a low thermal conductivity.

The housing may for example comprise aluminum or an aluminum alloy with a thermal conductivity of 150 W/(m*K) to 250 W/(m*K), copper or a copper alloy with a thermal conductivity of 350 W/(m*K) to 400 W/(m*K) or other metals with a thermal conductivity of greater than 100 W/(m*K).

The heat transfer element may for example comprise or consist of a metal, for example aluminum or an aluminum alloy or copper or a copper alloy, or a thermally conductive plastic material with a thermal conductivity of greater than 100 W/(m*K).

The heat transfer element may for example comprise or consist of aluminum nitride or aluminum nitride ceramic with a thermal conductivity of 50 W/(m*K) to 350 W/(m*K) or another electrically insulating material with similar thermal conductivity. The housing may comprise equivalent material.

The pin may comprise or consist of one or more of the materials aluminum, aluminum alloy, copper, aluminum nitride, aluminum nitride ceramic or plastic.

An advantage of the implementations described above is, that the occurring heat may dissipate faster from the heat source, which may be the imager chip on the circuit board, to the heat drain, which may be the housing and the environment. Using the thermally conductive material may enable a selection of a more powerful imager chip, which may increase the amount of heat, but may still be operable to efficient cooling.

According to at least one further embodiment, the heat transfer element comprises an electrically insulating material.

An electrical conductivity may represent a material's ability to conduct electric current and may be measured by Siemens per centimeter (S/cm). A material with an electrical conductivity below 10⁻⁸ S/cm may be categorized as an insulating material.

The heat transfer element may for example comprise aluminum nitride or aluminum nitride ceramic with a thermal conductivity of 10⁻¹¹ S/cm to 10⁻¹³ S/cm or another thermally conducting material with similar electrical conductivity.

An advantage of the implementations described above is, that a short circuit current from the circuit board to the housing via the heat transfer element may be avoided. This may increase a product safety and reliability without limiting a complete usage of the circuit board in terms of wiring traces or planes of the conductive layer. Additionally, the heat dissipation may be increased independent of an electric insulation.

According to at least one further embodiment, the automotive camera comprises an imager chip, which is assembled to the circuit board.

The imager chip may also be referred to as a digital image sensor, in particular a charge-coupled device (CCD) sensor, a metal-oxide-semiconductor (MOS) sensor, a complementary metal-oxide-semiconductor (CMOS) sensor or a similar sensor. The imager chip may be designed to capture an image in a digital manner and provide the image as a quantity of digital data.

The imager chip may be assembled to the circuit board for example by a soldering process, such that the light sensitive area of the imager chip is uncovered.

An advantage of the implementations described above is that the automotive camera may capture a high-resolution image with the imager chip and at the same time provide an efficient cooling mechanism for an occurring heat of the imager chip.

According to at least one further embodiment, the automotive camera comprises a lens unit, which is connected to the housing at a lens opening of the housing, so that incident light can penetrate the lens unit and the lens opening and hit the imager chip.

In other words, the incident light may penetrate the lens unit through the lens opening of the housing and impinge to the imager chip, so that the imager chip may capture the image.

The lens unit may comprise at least one optical lens, which may be designed to adapt a field of view to a predefined angle. The lens opening of the housing may be a flange or threat for example with a central through hole, which is designed to fit with the lens unit and align the lens unit with the housing and the imager chip.

An advantage of the implementations described above is, that the automotive camera may be used in various applications within a motor vehicle in a flexible way. The lens unit may be adapted to the individual needs of a position.

According to at least one further embodiment, the circuit board is connected to the housing opposite to the lens opening of the housing and the imager chip is arranged in a position, where a surface of the imager chip is hit at least by a part of the incident light.

The imager chip may be guided to the position in combination with the circuit board. The circuit board and the imager chip may in particular be connected in a rigid joint. The circuit board may be guided to a desired position via the pin and may have a certain degree of freedom for a final alignment. The final alignment may be performed individually for each single piece of similarly constructed automotive cameras due to a mechanical tolerance for example in a series production.

The surface of the imager chip may be a flat surface, which is designed to capture the image. The surface may also be referred to as an active surface due to a capability of actively transferring light information to digital image information.

An advantage of the implementations described above is, that the automotive camera may be easy to assemble and small in terms of an outer dimension. Nevertheless, the imager chip may capture the field of view.

According to at least one further embodiment, the circuit board is connected to the housing by at least one additional pin. The automotive camera comprises at least one additional heat transfer element, wherein each of the at least one additional pin passes through one of the at least one additional heat transfer element and each of the at least one additional heat transfer element is in contact with the housing via a first surface of the respective additional heat transfer element and with the circuit board via a second surface of the respective additional heat transfer element.

The at least one additional pin may be exactly two additional pins. A total number of pins may then for example be three pins and the circuit board may be guided to a predefined and fixed position via the three pins. Alternatively, the at least one additional pin may be exactly three additional pins. Then the total number of pins may for example be four pins. The circuit board may for example have a rectangular shape and each of the four pins may be placed in one of four corners of the circuit board.

The at least one additional pin may be connected to the circuit board, such that each of the at least one additional pin is inserted through one of at least one additional hole of the circuit board. Each of the at least one additional hole of the circuit board may be shaped as round hole, an elongated hole or a slot. The hole may also be open to the edge of the circuit board. Each of the at least one additional hole may have a different shape or have an identical shape. Alternatively, the at least one additional pin may touch the circuit board on at least one additional surface of the circuit board or be inserted into at least one additional blind hole of the circuit board. The at least one additional pin may also be soldered or glued to the circuit board.

The first surface of the at least one additional heat transfer element may be a flat surface and be in direct contact with the housing across an entire area of the first surface. In particular, the first surface may lie flat on the housing. The second surface of the at least one additional heat transfer element may be a flat surface and be in direct contact with the circuit board across an entire area of the second surface. In particular, the second surface may lie flat on the circuit board.

The at least one additional pin may for example be part of the housing and shaped as at least one additional protruding part of the housing. Alternatively, the housing may comprise at least one additional blind hole or at least one additional through hole and each of the at least one additional pin may be an individual part, which is connected to the at least one additional blind hole or the at least one additional though hole of the housing via a clamping process, a gluing process, a bonding process or as a rivet. The at least one additional pin may be screwed to the housing or the at least one additional pin itself may be designed as at least one additional screw.

The at least one additional heat transfer element may for example comprise aluminum nitride or aluminum nitride ceramic with the thermal conductivity of 50 W/(m*K) to 350 W/(m*K) or another electrically insulating material with similar thermal conductivity.

An advantage of the implementations described above is, that the heat transfer of occurring heat from the imager chip may be increased, in particular be significantly increased due to the higher quantity of heat transfer elements. Additionally, an assemble process of the circuit board is easier as the total number of pins may guide the circuit board to the predefined and fixed position with low tolerance. Furthermore, the stability of the circuit board inside the housing is increased.

According to at least one further embodiment, the heat transfer element is a hollow cylinder and the pin passes through a middle axis of the hollow cylinder.

The heat transfer element may for example have the shape of a washer, a spacer sleeve or a spacer tube. The first surface of the heat transfer element may for example be parallel to the second surface of the heat transfer element. The same may apply to the at least one additional heat transfer element.

An advantage of the implementations described above is the easy and cost effective production of the heat transfer element. Furthermore, the assembly of the heat transfer element in the automotive camera is simplified.

According to at least one further embodiment, the heat transfer element is a spring and the pin passes through a middle axis of the spring.

The heat transfer element may for example have the shape of a coil spring, a split washer or a spring lock washer. In particular, the heat transfer element may be brought into a designated position due to a press-on force and may be locked in place. In the designated position the heat transfer element may generate a counterforce, which may act to the housing and to the circuit board. The heat transfer element may overcome a part clearance or a part tolerance of the housing and the circuit board in order to safeguard the direct contact from the housing to the first surface of the heat transfer element as well as the direct contact from the circuit board to the second surface of the heat transfer element. Thus, the heat transfer element may safeguard a thermal contact between the housing and the circuit board.

An advantage of the implementations described above is, that a mechanical flexibility may overcome the part clearance or the part tolerance of the housing versus the circuit board. Especially when a pairing of the housing and the circuit board is overdetermined the heat transfer element may balance the tolerance and safeguard the thermal contact from the circuit board to the housing. An overdetermined pairing may refer to a pairing where a number of connections exceeds a number of possible rigid body movement options.

According to at least one further embodiment, the heat transfer element is a curved disc spring or a wave washer and the pin passes through a middle axis of the curved disc spring or the wave washer.

The heat transfer element may be brought into the designated position due to the press-on force and may be locked in place. In the designated position the heat transfer element may generate a further counterforce, which may act to the housing and to the circuit board. The heat transfer element may overcome the part clearance or the part tolerance of the housing and the circuit board in order to safeguard the direct contact from the housing to the first surface of the heat transfer element as well as the direct contact from the circuit board to the second surface of the heat transfer element. Thus, the heat transfer element may safeguard the thermal contact between the housing and the circuit board.

An advantage of the implementations described above is, that a further mechanical flexibility may overcome the part clearance or the part tolerance of the housing versus the circuit board. Especially for the overdetermined pairing the heat transfer element may balance the tolerance and safeguard the thermal contact from the circuit board to the housing. A further advantage of the implementations described above is the easy and cost effective production of the heat transfer element.

According to a further aspect of the invention, a motor vehicle comprising an automotive camera according to the invention or a camera system according to the invention is provided.

According to a further aspect of the invention, a method for manufacturing an automotive camera, in particular an automotive camera according to the invention, is provided.

According to several implementations of the method a pin is connected to a housing of the automotive camera within a housing interior of the housing. A heat transfer element is placed over the pin, such that the pin passes through the heat transfer element and the heat transfer element is in contact, particularly in direct contact, with the housing via a first surface of the heat transfer element. A circuit board is connected to the housing via the pin, such that the heat transfer element is in contact, particularly in direct contact, with the circuit board via a second surface of the heat transfer element.

The housing is, in particular, formed for arranging the circuit board of the automotive camera inside the housing interior of the housing. In some implementations of the method, the circuit board is arranged in the housing interior. The housing interior may for example be formed after a housing assembly of the housing.

The heat transfer element may be placed over the pin before the circuit board is connected to the housing. In particular the heat transfer element may not be removable in an assembled position of the circuit board without removing the circuit board first. The housing may be designed to have a gap between the circuit board and the housing and the gap is at least partially filled with the heat transfer element.

The automotive camera may comprise a lens unit and the housing may comprise a lens opening. The lens unit may be assembled to the housing at the lens opening, so that incident light may penetrate the lens unit and the lens opening along an optical axis of the lens unit. During a placement of the circuit board via the pin, an imager chip, which may be assembled to the circuit board, may be aligned with the optical axis, so that the incident light may impinge to the imager chip.

According to at least one further embodiment, the heat transfer element and/or the housing is produced from thermally conductive material.

The housing may for example comprise aluminum or aluminum alloy with a thermal conductivity of 150 W/(m*K) to 250 W/(m*K), copper or copper alloy with a thermal conductivity of 350 W/(m*K) to 400 W/(m*K) or other metals with a thermal conductivity of greater than 100 W/(m*K). The heat transfer element may for example comprise equivalent material.

The heat transfer element may for example comprise aluminum nitride or aluminum nitride ceramic with a thermal conductivity of 50 W/(m*K) to 350 W/(m*K) or another electrically insulating material with similar thermal conductivity. The housing may comprise equivalent material.

According to at least one further embodiment, the heat transfer element and/or the housing is produced by means of an extrusion process or by means of a molding process.

Further implementations of the method for manufacturing an automotive camera according to the invention follow directly from the various implementations of the automotive camera according to the invention and vice versa. In particular, individual features and/or explanations with respect to the various implementations of the automotive camera according to the invention may apply analogously for respective implementations of the method according to the invention and vice versa.

Further features of the invention are evident from the claims, the figures, and the description of the figures. The features and feature combinations previously mentioned in the description as well as the features and the feature combinations mentioned in the following in the description of the figures and/or shown in the figures may be contained by the invention not only in the respective indicated combination, but also in other combinations. In particular, embodiments and feature combinations, which do not comprise all features of an originally formulated claim, are also comprised by the invention. Moreover, embodiments and feature combinations, which go beyond the feature combinations set out in the recitations of the claims or deviate from these, are comprised by the invention.

In the following the invention is explained in detail with regard to special exemplary implementations and respective schematic drawings. In the drawings, identical or functionally identical elements may be equipped with the same reference signs. The description of identical or functionally identical elements is not necessarily repeated with regard to various figures.

In the figures:
- Fig. 1: shows schematically a motor vehicle with an exemplary implementation of an automotive camera according to the invention;
- Fig. 2: shows schematically an exploded side view and an exploded perspective view of a further exemplary implementation of an automotive camera according to the invention;
- Fig. 3: shows schematically a side view of a further exemplary implementation of an automotive camera according to the invention;
- Fig. 4: shows schematically a perspective view of a housing, a pin and a heat transfer element of a further exemplary implementation of an automotive camera according to the invention;
- Fig. 5: shows schematically a perspective view of a circuit board, a pin and a heat transfer element of a further exemplary implementation of an automotive camera according to the invention; and
- Fig. 6: shows schematically a cross sectional view of a further exemplary implementation of an automotive camera according to the invention.

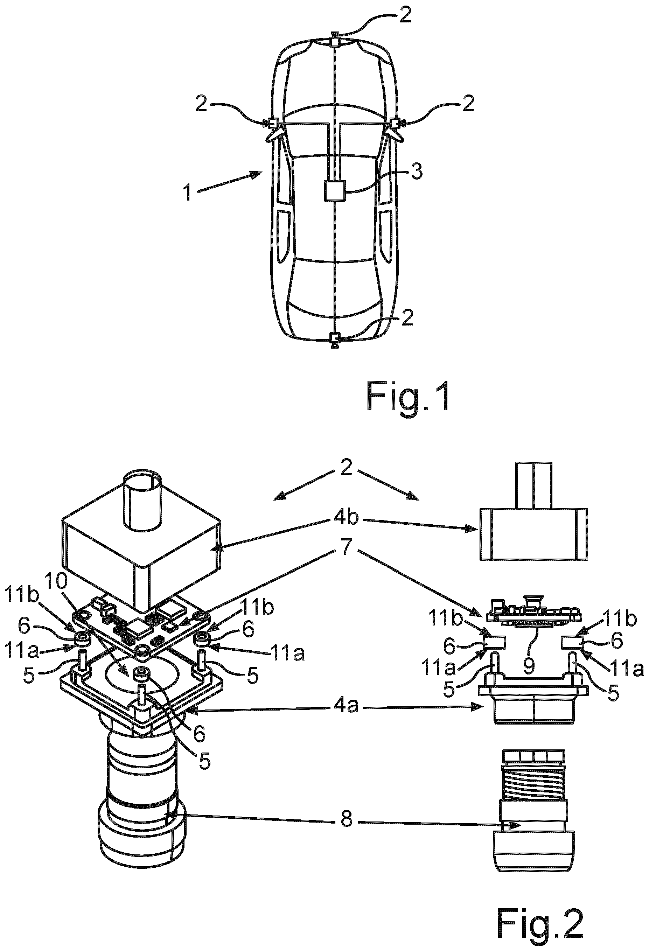

In Fig. 1, a motor vehicle 1 comprising at least one automotive camera 2, for example a front camera, one or more side cameras and/or a rear camera, which is implemented according to an exemplary embodiment of the present invention is shown in a top view. Here, the motor vehicle 1 is formed as a passenger car as a non-limiting example. The motor vehicle 1 may for example comprise a control unit 3 to control the at least one automotive camera 2 and/or to receive camera images from the at least one automotive camera 2.

An automotive camera 2 comprises a housing 4a, 4b and a circuit board 7, which is arranged within a housing interior of the housing 4a, 4b, wherein the circuit board 7 is connected to the housing 4a, 4b by a pin 5, and a heat transfer element 6, wherein the pin 5 passes through the heat transfer element 6 and the heat transfer element 6 is in contact with the housing 4a, 4b via a first surface 11a of the heat transfer element 6 and with the circuit board 7 via a second surface 11b of the heat transfer element 6.

In the shown example, the motor vehicle 1 comprises for example four automotive cameras 2, which are distributed around the motor vehicle 1. One of the automotive cameras 2 is arranged in a rear area, one of the automotive cameras 2 is arranged in a front area of the motor vehicle 1 and the remaining two automotive cameras 2 are arranged in respective lateral areas, in particular in vicinities of the wing mirrors. The number and arrangement of the automotive cameras 2 may, however, be different in other examples. Alternatively or in addition, one or more automotive cameras according to the invention may be arranged for capturing an interior space or a passenger compartment of the motor vehicle 1.

The automotive cameras 2 are, in particular, installed to a respective individual motor vehicle component. The motor vehicle component may for example be a bumper or an exterior mirror or a side trim. The motor vehicle component may also be a headliner or an interior trim or a cover of a steering wheel center or an interior mirror. The mentioned motor vehicle components are to be considered only as non-limiting examples.

In an embodiment, an environmental region of the motor vehicle 1 may be captured by an automotive camera 2. In particular, an image sequence or video data, which describes the environmental region, can be provided by the automotive camera 2. The video data may be transmitted from the automotive camera 2 to the control unit 3. By means of the control unit 3, a display device (not shown) of the motor vehicle 1 may be controlled such that the video data of the automotive camera 2 can be displayed to a user of the motor vehicle 1. Thus, the electronic vehicle guidance system may operate as a driver assistance system for assisting a driver of the motor vehicle 1 in driving the motor vehicle 1. Alternatively or in addition, the control unit 3 may process the video data and generate at least one control signal for one or more respective actuators (not shown) of the motor vehicle 1, which may control the motor vehicle 1 automatically or in part automatically based on the control signals.

Fig. 2 shows an exploded perspective view on the left and a corresponding exploded side view on the right, of an exemplary implementation of an automotive camera 2 according to the invention, which may be used in a motor vehicle 1 or the corresponding electronic vehicle guidance system described with respect to Fig. 1, for example.

The automotive camera 2 comprises a housing 4a, 4b and a lens unit 8, which is attached to the housing 4a, 4b and comprises an optical axis.

The housing 4a, 4b may comprise a lens opening 10 formed by a through hole, which is aligned with the optical axis of the lens unit 8 to allow for light entering the automotive camera 2 via the lens unit 8. Within a housing interior of the housing 4a, 4b, a circuit board 7 of the automotive camera 2 may be arranged. The circuit board 7 may carry an imager chip 9 of the automotive camera 2, which is also aligned with the optical axis. Therefore, light entering the automotive camera 2 through the lens unit 8 and the lens opening 10 may hit an active optical surface of the imager chip 9. The imager chip 9 may generate respective imager signals, which may be transmitted to the control unit 3 via an opening in the housing 4a, 4b and a corresponding cable connection (not shown) or wireless connection. Alternatively, the circuit board 7 may comprise pre-processing circuitry, such as a digital signal processor, DSP, a microcontroller, a graphics processing unit, GPU, et cetera, to pre-process the imager signals and to provide the pre-processed imager signals to the control unit 3. The control unit 3 may then generate video data depending on the imager signals or the pre-processed imager signals, respectively.

In several embodiments, the housing 4a, 4b may for example comprise a front housing 4a and a rear housing 4b as shown in Fig. 2. In this case a part of described features, in particular all described features, of the housing 4a, 4b may apply to the front housing 4a. Alternatively, the housing 4a, 4b may comprise more than two parts or consist of a single piece.

According to the invention, the circuit board 7 is connected to the housing 4a, 4b with one or more pins 5. Fig. 2 shows an exemplary implementation of the automotive camera 2 with several of the pins 5. A heat transfer element 6 is placed over the pin 5, such that the housing 4a, 4b is in contact with a first side of the heat transfer element 6 and the circuit board 7 is in contact with a second side of the heat transfer element 6.

The heat transfer element 6 may for example be implemented as a washer, a spacer sleeve or a spacer tube. Alternatively, the heat transfer element 6 may be implemented as a coil spring, a split washer or a spring lock washer.

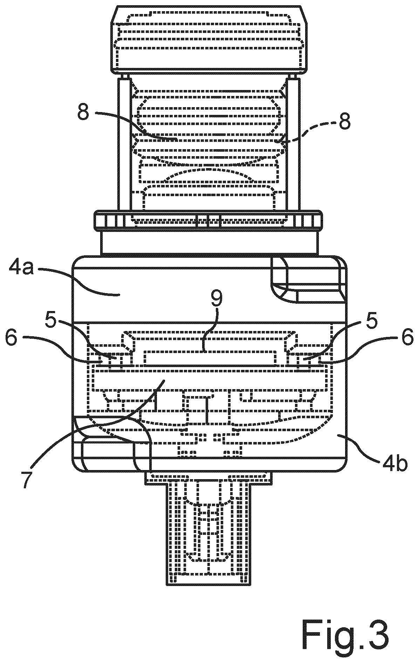

Fig. 3 shows a side view of an exemplary implementation of an automotive camera 2 according to the invention. The automotive camera 2 is shown in an assembled state. The lens unit 8 may be connected to the housing 4a, 4b. The imager chip 9 may be soldered to the circuit board 7 and for example positioned perpendicular to the optical axis of the lens unit 8. The circuit board 7 may be connected to the housing 4a, 4b within the housing interior via the pin 5. The heat transfer element 6 may be placed over the pin 5. A gap may be formed between a surface of the circuit board 7 and a surface of the housing 4a, 4b. The heat transfer element 6 may at least partially fill the gap between the circuit board 7 and the housing 4a, 4b. The first side of the heat transfer element 6 and the second side of the heat transfer element 6 may be parallel to each other.

The housing 4a, 4b may seal the housing interior in an air-tight or partially air-tight manner, such that only few or no exchange of air from the housing interior to an environment outside the housing 4a, 4b may be possible. Thus, a ventilation of the circuit board 7 may not be possible or may be limited.

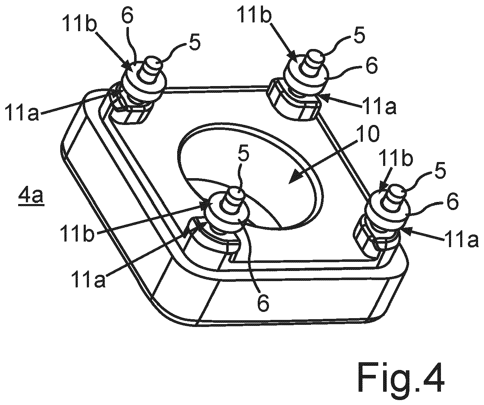

Fig. 4 shows a perspective view of an exemplary implementation of the housing 4a, 4b, the pin 5 and the heat transfer element 6 according to the invention. The shown example comprises a number of four pins 5 and four heat transfer elements 6 respectively, which are arranged in a rectangular layout around the lens opening 10. The number and arrangement of the pins 5 and heat transfer elements 6 may, however, be different in other examples.

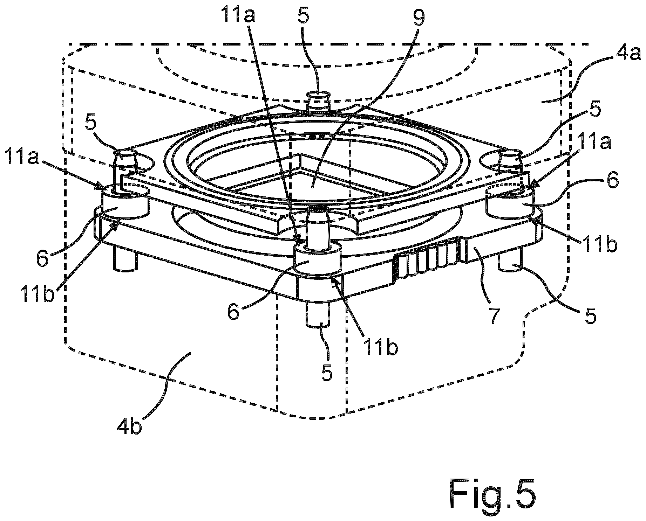

Fig. 5 shows a perspective view of an exemplary implementation of an automotive camera 2 according to the invention. The circuit board 7 may be connected to the housing 4a, 4b via the pin 5 and in particular by at least one additional pin 5. The heat transfer element 6 may be placed over the pin 5 and establish a thermal connection between the circuit board 7 and the housing 4a, 4b. In particular at least one additional heat transfer element 6 may be placed over one of the at least one additional pin 5.

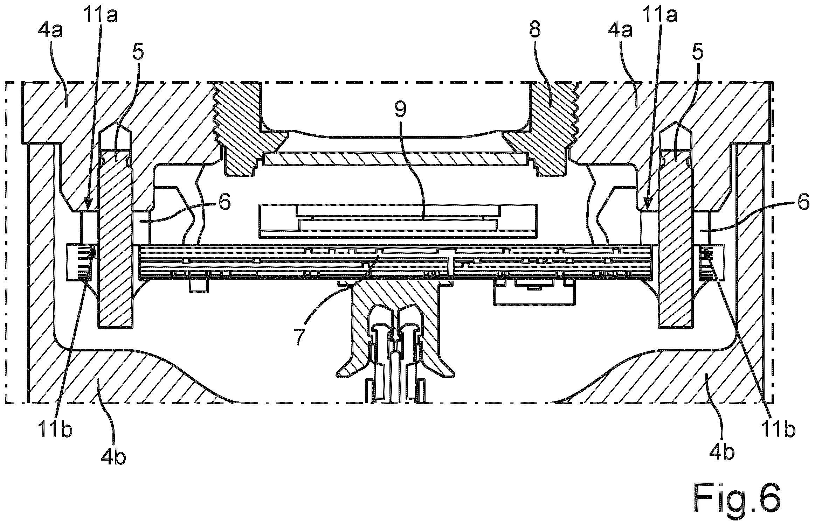

Fig. 6 shows a cross sectional view of an exemplary implementation of an automotive camera 2 according to the invention. The imager chip 9 and at least one additional component on the circuit board 7 may generate heat. The heat or a major part of the heat may be transferred to the circuit board 7. The at least one heat transfer element 6 may transfer the major part of the heat or most of the major part of the heat to the housing 4a, 4b. In addition, the pin 5 may also transfer an additional part of the major part of the heat to the housing 4a, 4b. The housing 4a, 4b may dissipate the heat or a significant part of the heat to the environment outside the housing 4a, 4b. The heat transfer element 6 may be part of an effective chain of cooling components with a high thermal conductivity, which may cool the imager chip 9 and establish a working temperature in the housing interior, which is suitable for a powerful imager chip 9.

## Claims

1. Automotive camera (2) comprising
- a housing (4a, 4b) and a circuit board (7), which is arranged within a housing interior of the housing (4a, 4b), wherein the circuit board (7) is connected to the housing (4a, 4b) by a pin (5); and
- a heat transfer element (6), wherein the pin (5) passes through the heat transfer element (6) and the heat transfer element (6) is in contact with the housing (4a, 4b) via a first surface (11a) of the heat transfer element (6) and with the circuit board (7) via a second surface (11b) of the heat transfer element (6).

2. Automotive camera (2) according to claim 1, wherein a gap between a surface of the circuit board (7) and a surface of the housing (4a, 4b) is formed, wherein the gap is at least partially filled by the heat transfer element (6).

3. Automotive camera (2) according to one of the preceding claims, wherein the heat transfer element (6) and/or the housing (4a, 4b) comprises a thermally conductive material.

4. Automotive camera (2) according to one of the preceding claims, wherein the heat transfer element (6) comprises an electrically insulating material.

5. Automotive camera (2) according to one of the preceding claims, wherein the automotive camera (2) comprises an imager chip (9), which is assembled to the circuit board (7).

6. Automotive camera (2) according to claim 5, wherein the automotive camera (2) comprises a lens unit (8), which is connected to the housing (4a, 4b) at a lens opening (10) of the housing (4a, 4b), so that incident light can penetrate the lens unit (8) and the lens opening (10) and hit the imager chip (9).

7. Automotive camera (2) according to claim 5 and 6, wherein the circuit board (7) is connected to the housing (4a, 4b) opposite of the lens opening (10) of the housing (4a, 4b) and the imager chip (9) is arranged in a position, where a surface of the imager chip (9) is hit by the incident light.

8. Automotive camera (2) according to one of the preceding claims,
- wherein the circuit board (7) is connected to the housing (4a, 4b) by at least one additional pin (5); and
- comprising at least one additional heat transfer element (6), wherein each of the at least one additional pin (5) passes through one of the at least one additional heat transfer element (6) and each of the at least one additional heat transfer element (6) is in contact with the housing (4a, 4b) via a first surface (11a) of the respective additional heat transfer element (6) and with the circuit board (7) via a second surface (11b) of the respective additional heat transfer element (6).

9. Automotive camera (2) according to one of the preceding claims, wherein the heat transfer element (6) is a hollow cylinder and the pin (5) passes through a middle axis of the hollow cylinder.

10. Automotive camera (2) according to one of the claims 1 to 8, wherein the heat transfer element (6) is a spring and the pin (5) passes through a middle axis of the spring.

11. Automotive camera (2) according to one of the claims 1 to 8, wherein the heat transfer element (6) is a curved disc spring or a wave washer and the pin (5) passes through a middle axis of the curved disc spring or the wave washer.

12. Motor vehicle (1) comprising an automotive camera (2) according to one of the preceding claims.

13. Method for manufacturing an automotive camera (2), wherein
- a pin (5) is connected to a housing (4a, 4b) of the automotive camera (2) within a housing interior of the housing (4a, 4b);
- a heat transfer element (6) is placed over the pin (5), such that the pin (5) passes through the heat transfer element (6) and the heat transfer element (6) is in contact with the housing (4a, 4b) via a first surface (11a) of the heat transfer element (6);
- a circuit board (7) is connected to the housing (4a, 4b) via the pin (5), such that the heat transfer element (6) is in contact with the circuit board (7) via a second surface (11b) of the heat transfer element (6).

14. Method according to claim 13, wherein the heat transfer element (6) and/or the housing (4a, 4b) is produced from thermally conductive material.

15. Method according to one of the claims 13 or 14, wherein the housing (4a, 4b) is produced by means of an extrusion process or by means of a molding process.
